# EUROPEAN PATENT APPLICATION

(11) **EP 1 336 984 A2**
(43) Date of publication of application: **20.08.2003**
(21) Application number: 03003360.9
(22) Date of filing: 13.02.2003
(51) Int. Cl.: H01J 37/32

(54) **Method and apparatus for providing modulated bias power to a plasma etch reactor**

(30) Priority: 13.02.2002 US 76721
(71) Applicant: Applied Materials, Inc., Santa Clara, California 95054 (US)
(72) Inventor: Weikmann, Elisabeth, 83677 Reichersbeuern (DE); Diaz Jr. Aduato, Mountain View, CA 94041 (US); Pamarthy, Sharma V., Hayard, CA 94541 (US); Kumar, Ajay, Sunnyvale, CA 94087 (US); Nallan, Padmapani C., San José, CA 95148 (US)
(74) Representative: Zimmermann, Gerd Heinrich

(57) **Abstract**

A method and apparatus for modulating the bias power applied to a wafer support pedestal (206) within a plasma etch reactor (200). The modulation has an on/off duty cycle of between 10 and 90 percent. Such modulation of the bias power substantially improves the verticality of the etched features located near the edge of a semiconductor wafer (300) as the wafer is being etched in a plasma etch reactor.

## Description

The present invention generally relates to plasma etch reactors and, more particularly, to a method and apparatus for providing modulated bias power to a plasma etch reactor.

Plasma etch reactors are commonly used for etching trenches and vias in semiconductor wafers. These reactors contain a volume within which a semiconductor wafer is supported. At least one reactive gas is supplied to the volume and an RF signal is either inductively or capacitively coupled to the reactive gas to form a plasma. The plasma etches the semiconductor wafer that is positioned within the reactor.

To protect the edge and backside of the wafer from being exposed to the plasma, a ring is placed around the edge of the wafer as the wafer sits on a wafer support pedestal. The ring abuts the peripheral edge of the semiconductor wafer. This ring is generally made of a dielectric material such as quartz or ceramic and it is a part of the process kit.

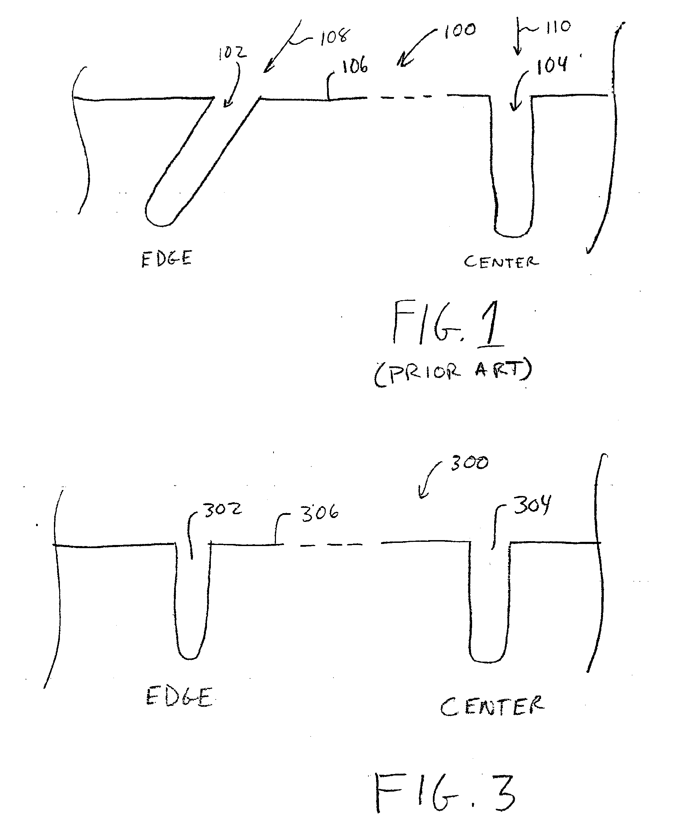

Empirical study has shown that the ring distorts the trajectory of the ions within the reactive gas plasma at a location near the ring-to-wafer contact point. Furthermore, the characteristics of the distortion vary with ring and process kit geometry. Generally, it is desirable that the ions have a trajectory that is orthogonal to the wafer surface. However, near the ring, the trajectory of the ions is not orthogonal to the wafer surface. As such, the ions are orthogonal to the wafer surface near the center of the wafer and near the ring the ions are non-orthogonal. Consequently, etched features formed in the center of the wafer are vertical, and etched features formed at the edge of the wafer lean outward or inward towards the center of the wafer, depending on the kit's geometry. Figure 1 depicts center and edge portions of a wafer 100 having etched features, e.g., trenches 102 and 104, etched in the surface 106 of the wafer 100. The ion trajectory at the center of the wafer is illustrated by arrow 110, while the ion trajectory at the edge is illustrated by arrow 108. Trench 104, at the center of the wafer, is substantially vertical. In comparison, trench 102, within approximately 3 mm of the edge of the wafer, leans inward.

Therefore, there is a need in the art for a method and apparatus that improves the verticality of trenches located near the edge of the wafer.

The present invention intends to overcome at least some of the above problems. The object is solved by the method of etching a wafer according to independent claim 1 and the apparatus for etching a wafer according to independent claim 14.

Further advantages, features, aspects and details of the invention are evident from the dependent claims, the description and the accompanying drawings.

The disadvantages associated with the prior art are overcome by a method and apparatus that modulates the bias power applied to a wafer support pedestal within a plasma etch reactor. In one embodiment, the modulation creates an on/off duty cycle of between 10 and 90 percent. Such modulation of the bias power substantially improves the verticality of the etched features located near the edge of a semiconductor wafer as the wafer is being etched in a plasma etch reactor.

The invention is also directed to apparatus for carrying out the disclosed methods and including apparatus parts for performing each described method step. These method steps may be performed by way of hardware components, a computer programmed by appropriate software, by any combination of the two or in any other manner. Furthermore, the invention is also directed to methods by which the described apparatus operates. It includes method steps for carrying out every function of the apparatus.

So that the manner in which the above recited features of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.
Figure 1 depicts portions of a semiconductor wafer etched in accordance with the prior art;
Figure 2 depicts a plasma etch reactor having modulated bias power in accordance with one embodiment of the invention;
Figure 3 depicts portions of a semiconductor wafer etched in accordance with one embodiment of the present invention; and
Figure 4 depicts a timing diagram of the modulated bias power in accordance with one embodiment of the present invention.

Figure 2 depicts a plasma etch reactor 200 (commonly referred to as an inductively coupled plasma source (IPS) etch reactor or chamber) incorporating one embodiment of the present invention. The plasma etch reactor 200 comprises a dome 212, at least one side 214 and a bottom 216. The dome 212, at least one side 214 and bottom 216 define a volume 222 in which a reactive gas is supplied by gas source 218. A wafer 220 is supported on a wafer support pedestal 206 within the volume 222. Proximate the edge of the wafer is a ring 212 having a surface 224 of an inner diameter of the ring 212 that abuts the edge of the wafer 220.

To etch the wafer, the reactive gas is formed into a plasma by applying inductively coupled RF energy to the volume 222 from an antenna 202. The antenna 202 is supplied with power from a source power supply 204 at a frequency of approximately 12.56 MHz and a power level of between 300-2000 watts. The source power is applied continuously during the etch processing of the wafer.

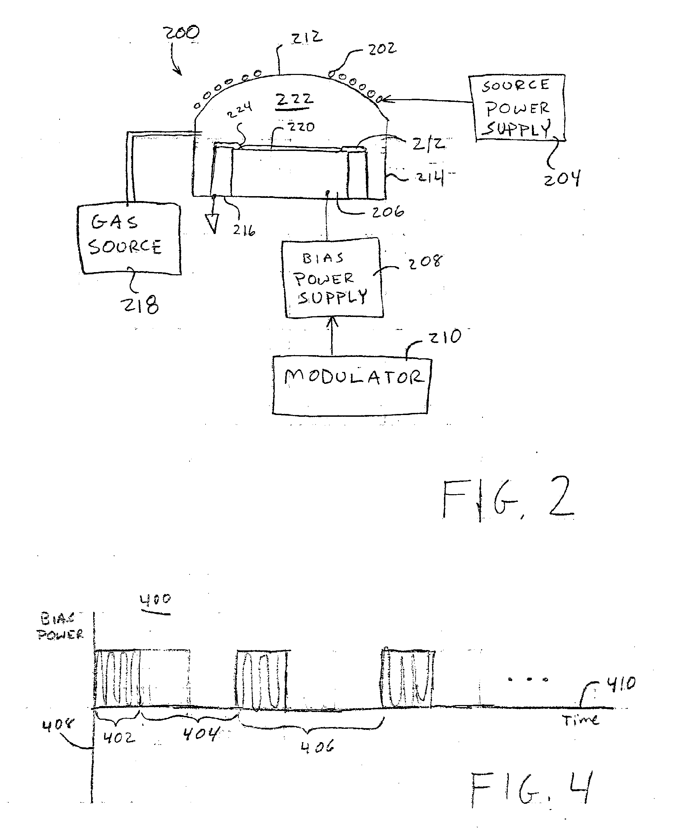

Bias power is coupled from the bias power supply 208 to the pedestal 206 (cathode). Alternatively, the bias power may also be coupled to the ring 212. The bias power controls the ion energy within the plasma by capacitively coupling energy to the ions. The bias power produced by the bias power supply 208 is modulated by a modulator 210 to cause, in one embodiment, the bias power to be pulsed. Other modulation forms other then pulsed may also be used. The modulator 210 may be an electronic modulation circuit, or as simple as an RF switch at the output of the bias power supply 208. Although the modulator 210 is depicted as a separate circuit in Figure 2, those skilled in the art will realize that the circuit may be integrated into the bias power supply 208. The bias power is a 400 kHz signal having a peak power level of between 5 and 500 watts and is, for example, 30 watts. The duty cycle of the on/off pulsing is between 10 and 90 percent. The cycle time (i.e., on time plus off time) may be in the range of one millisecond to over a minute. FIG. 4 depicts a graph 400 (bias power 408 versus time 410) of the modulation for one embodiment of the invention. This embodiment uses an on-time 402 of 6 milliseconds and an off-time 404 of 12 milliseconds forming a duty cycle of 33 percent and a cycle time 406 of 18 milliseconds. The cycle time and/or duty cycle may be adjustable to optimize utilization of the bias power. For example, the modulated bias power can also repeatedly be applied for about 2 milliseconds to 20 milliseconds of on-time and for about 4 milliseconds to 40 milliseconds of off-time.

Illustrative plasma etch reactors that may be used to implement the invention is a Decoupled Plasma Source (DPS) etch reactor or a DPS-II etch reactor, both of which are manufactured by Applied Materials, Inc. of Santa Clara, California. These reactors produce a plasma by inductively coupling energy from an antenna to the reactive gas. The ion energy within the plasma is controlled by the RF bias power that is applied to the pedestal. Other inductively coupled etch reactors, as well as capacitively coupled etch reactors, can be used in conjunction with the present invention to improve the uniformity of ion trajectories in the plasma.

To etch a semiconductor wafer, the wafer 220 is placed within the chamber. The reactive gas is supplied from the gas source 218 to the volume 222. The gas may be supplied through the dome 212, sidewall 214 or bottom 216 of the reactor 200. Source power is then continuously applied to the antenna 202 to form a plasma that causes the reactive gas plasma to etch the wafer 220. Reactive gas for etching silicon is typically a fluorine-based gas such as sulfur hexafluoride (SF₆). Modulating the bias power throughout the etching process causes the trajectory of the ions within the reactive gas plasma to remain orthogonal to the wafer surface even at the edges of the wafer. As such, the edge features are as vertical as the center features. Additionally, modulating the bias power also effects the degree of passivation that occurs during the etch process. While the bias power is off, a passivation layer is deposited on the wafer. During the period when the bias power is on, the passivation layer is removed by an etchant plasma. Consequently, modulating the bias power is useful in not only uniform etching of vertical features, but also controlling sidewall contour, profile and texture through passivation layer control. The formation and use of passivation layers during etching is generally well-known in the art of high aspect ration trench formation. However, bias power modulation has not been used to control the passivation layer formation.

Figure 3 depicts an illustration of portions of a wafer 300 having a surface 306 in which trenches 302 and 304 have been formed using a modulated bias power. The trench 304 near the center of the wafer is as vertical as the trench 302 near the edge of the wafer. As a result of the pulsed bias power, the trajectory of the ions in the plasma is uniform, i.e., the ions are orthogonal to the surface of the wafer across the entire wafer surface. As such, the present invention substantially improves the verticality of the trenches near the edge of the wafer, e.g., trenches that are within 3 mm of the edge of the wafer.

While foregoing is directed to the preferred embodiment of the present invention, other and further embodiments of the invention may be devised without departing from the basic scope thereof, and the scope thereof is determined by the claims that follow.

## Claims

1. A method of etching a wafer in a plasma etch reactor, where the wafer is supported in a volume within the plasma etch reactor upon a wafer support pedestal, the method comprising:
supplying a reactive gas to the volume;
generating a plasma within the volume; and
applying modulated bias power to the wafer support pedestal.

2. The method according to claim 1, wherein the applying modulated bias power step further comprises applying bias power at an on/off duty cycle between 10 and 90 percent.

3. The method according to claim 2, wherein the on/off duty cycle is 33 percent.

4. The method according to any of the preceding claims, wherein said step of applying modulated bias power is repeatedly applied for 6 milliseconds of on-time and 12 milliseconds of off-time.

5. The method according to any of the preceding claims, wherein the bias power has a peak power of between 5 and 500 watts.

6. The method according to any of the preceding claims, wherein the bias power has a peak power of 30 watts.

7. The method according to any of the preceding claims, wherein the reactive gas is a silicon etchant.

8. The method according to any of the preceding claims, wherein the generating step further comprises:
continuously applying source power to an antenna located proximate the volume.

9. The method according to claim 8, wherein the source power is between 300 and 2000 watts.

10. The method according to any of the preceding claims, wherein bias power has a cycle time of between one millisecond and one minute.

11. The method according to any of the preceding claims, wherein the generating step further comprises capacitively coupling energy to the reactive gas to form the plasma.

12. The method according to any of the preceding claims, wherein the generating step further comprises inductively coupling energy to the reactive gas to form the plasma.

13. The method according to any of the preceding claims, wherein the modulated bias power controls the formation of a passivation layer upon the wafer.

14. Apparatus for etching a wafer comprising:
a plasma etch reactor (200) comprising a volume (222) and a wafer support pedestal (206) that supports the wafer in said volume;
a gas source (218) for supplying a reactive gas to the volume;
a source power supply (204) for applying energy to the reactive gas and forming a plasma in the volume; and
a bias power supply (208), coupled to the wafer support pedestal, for supplying a modulated bias power.

15. The apparatus according to claim 14, wherein the reactive gas is a silicon etchant.

16. The apparatus according to any of claims 14 to 15, wherein the plasma etch reactor further comprises an antenna (202) that is located proximate the volume and said source power supply (204) is coupled to the antenna.

17. The apparatus according to any of claims 14 to 16, wherein the source power supply applies a source power of between 300 and 2000 watts.

18. The apparatus according to any of claims 14 to 17, wherein the modulated bias power has an on/off duty cycle of between 10 to 90 percent.

19. The apparatus according to any of claims 14 to 18, wherein the modulated bias power has an on/off duty cycle of 33 percent.

20. The apparatus according to any of claims 14 to 19, wherein the modulated bias power has a peak power level of between 5 and 500 watts.

21. The apparatus according to any of claims 14 to 20, wherein the modulated bias power has a peak power level of 30 watts.

22. The apparatus according to any of claims 14 to 21, wherein the energy is capacitively coupled to the reactive gas.

23. The apparatus according to any of claims 14 to 22, wherein the energy is inductively coupled to the reactive gas.
